(19) Europäisches Patentamt
European Patent Office
Office européen des brevets

(11) Publication number: **0 366 077 B1**

# (12) EUROPEAN PATENT SPECIFICATION

(45) Date of publication of patent specification: **26.01.94** (51) Int. Cl.[5]: **G03F 7/033**

(21) Application number: **89119737.8**

(22) Date of filing: **24.10.89**

The file contains technical information submitted after the application was filed and not included in this specification

## (54) Photopolymerizable resin composition.

(30) Priority: **24.10.88 JP 267662/88**

(43) Date of publication of application:
**02.05.90 Bulletin 90/18**

(45) Publication of the grant of the patent:
**26.01.94 Bulletin 94/04**

(84) Designated Contracting States:
**DE FR GB IT**

(56) References cited:
**EP-A- 0 141 921**
**EP-A- 0 194 440**
**EP-A- 0 283 990**
**DE-A- 3 600 442**

(73) Proprietor: **TOKYO OHKA KOGYO CO., LTD.**
**150, Nakamaruko**
**Nakahara-ku**
**Kawasaki-shi Kanagawa-ken 211(JP)**

(72) Inventor: **Onodera, Junichi**
**8-23 Ichnomiya 7-chome**
**Samukawa-machi**
**Koza-gun Kanagawa-ken 253-01(JP)**
Inventor: **Otawa, Shigeru**
**102 Green height Tsuruma**
**4-6 Tsuruma 1-chome**
**Yamato-shi Kanagawa-ken 242(JP)**

(74) Representative: **Neidl-Stippler, Cornelia, Dr.**
**Neidl-Stippler & Partner**
**Rauchstrasse 2**
**D-81679 München (DE)**

EP 0 366 077 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a photopolymerizable resin composition which is suitable for the production of a printed circuit board and may be developed with an aqueous alkaline solution and more particularly to a photopolymerizable resin composition developable with an aqueous weak alkaline solution.

A printed circuit board is prepared by e. g. either coating a copper surface of a copper-clad laminate or a surface of a flexible printed board with a solution of a photopolymerizable resin composition or laminating on the surface of a copper substrate a photopolymerizable film formed by previously coating or pouring the composition into a film to form a resist film, selectively exposing the resist film to an actinic radiation to form a latent image, developing said image with a developer comprising an aqueous alkaline solution or the like to form a resist image on the copper substrate, and subjecting the copper surface not protected by the resist image to etching treatment or metal plating.

Particularly, in recent years, a laminate having a three-layer structure which is developable with an aqueous alkaline solution and flexible, i.e, a dry film resist comprising a support film layer, a photopolymerizable resin layer, and a protective film, has been strongly demanded in order to improve workability, problems caused by air pollution, and yield.

In general a resin composition comprising a carboxylated acrylic copolymer, a photopolymerizable monomer, and a photopolymerization initiator has been employed as the photopolymerizable resin composition developable with an aqueous alkaline solution.

From DE-A-36 00 442 photopolymerizable compositions are generally known comprising besides the usual ethylenic unsaturated compounds and initiators benzotriazolecarboxylic acid as adhesion promotor and a linear vinyl copolymer, especially a linear acrylic copolymer from methacrylic acid, hydroxypropylmethacrylate, methylmethacrylate.

EP-A-141921 discloses photopolymerizable resist compositions having as a binder a polymer with residues of the general formula -$CH_2$-O-R, wherein R may be hydrogen, a lower alkyl, acyl or hydroxy alkyl group.

Generally, photopolymerizable resin compositions of the above described type, developable with an aqueous alkaline solution are used as a dry film resist for a flexible printed board and the flexibility is unsufficient because the glass transition point of the photopolymerizable resin composition is high. This makes the resist film formed on the flexible printed board susceptible to cracking. Cracks lead to failure of the printed board such as the breaking of wires.

When the above described dry film resist is used as an etching resist for etching a copper-clad laminate having a through-hole, problems such as penetration of an etchant into a gap formed between the resist film and the copper surface because of poor adhesion of the copper surface to the resist film provided so as to cover the through-hole, or there occurs cracking due to poor flexibility of the photopolymerizable resin composition, which causes the etchant to penetrate thereinto, so that the copper surface covered by the resist film is etched as well.

The problems of the state of the art are solved by a photopolymerizable resin composition which is suitable for the production of a printed circuit board and may be developed with an aqueous alkaline solution, which composition is mainly composed of:

a) a linear acrylic copolymer, having a weight-average molecular weight of 30,000 to 200,000 and a glass transition of 20° to 80°C, and comprising

(i) at lease one comonomer represented by the following general formula:

$$CH_2=\underset{\displaystyle X}{\underset{|}{C}}-CO-Y-Z-OH$$

wherein

X is a hydrogen atom or a methyl group

Y is an oxygen atom or an imino group and

Z is an alkylene group having 1 to 5 carbon atoms,

in an amount of 1 to 30 wt.% based on the total amount of the comonomers;

(ii) an ethylenically unsaturated comonomer having a carboxyl group in a amount of 10 to 25 wt.%, based on the total amount of the comonomers; and

iii) at least one comonomer selected from the group consisting of acrylonitrile and methacrylonitrile in an amount of 10 to 30 wt.% based on the total amount of the comonomers;

b) an ethylenically unsaturated compound in an amount of 10 to 100 parts by weight based on 100 parts by weight of the linear acrylic copolymer;

c) a photopolymerizable initiator in an amount of 1 to 15 parts by weight based on 100 parts by weight of the linear acrylic copolymer; and

d) a benzotriazolecarboxylic acid.

Due to the intensive studies of the inventors it has been found that the use of the particular linear acrylic polymer as binder component of the resist can render a remarkable improvement in the flexibility of the resist film.

Features of the present invention will now be described in detail.

At the outset, each of the above-described components will be described in detail.

Component (a)

Component (a) of the photopolymerizable resin composition according to the present invention is a linear acrylic copolymer prepared by copolymerizing the following monomers (i), (ii) and (iii) as essential comonomers:

(i) at least one compound represented by the following general formula:

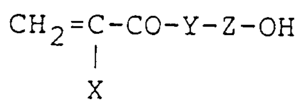

wherein X is a hydrogen atom or a methyl group, Y is an oxygen atom or an imino group and Z is an alkylene group having 1 to 5 carbon atoms,

(ii) an ethylenically unsaturated compound having a carboxyl group, and

(iii) at least one comonomer selected from the group consisting of acrylonitrile and methacrylonitrile in an amount of 10 to 30 wt.% based on the total amount of the comonomers.

The above-described comonomer (i) is contained in an amount of 1 to 30% by weight based on the total amount of the comonomers. When the amount of comonomer (i) is below this range, the flexibility is insufficient, while when it is above this range, also a portion unexposed with an actinic radiation becomes insoluble in an aqueous alkaline solution unfavorably.

Specific examples of the above-described comonomer (i) include 2-hydroxyethyl acrylate, 2-hydroxyethyl methacrylate, 2-hydroxypropyl acrylate, 2-hydroxypropyl methacrylate, 3-hydroxybutyl acrylate, 3-hydroxybutyl methacrylate, 5-hydroxypentyl acrylate, 5-hydroxypentyl methacrylate, hydroxymethylacrylamide, hydroxymethylmethacrylamide, 2-hydroxyethylacrylamide, 2-hydroxyethylmethacrylamide, 2-hydroxypropylacrylamide, 2-hydroxypropylmethacrylamide, 3-hydroxybutylacrylamide, 3-hydroxybutylmethacrylamide, 5-hydroxypentylacrylamide, and 5-hydroxypentylmethacrylamide.

The above-described comonomer (ii) is an ethylenically unsaturated compound having a carboxyl group, and is contained in an amount of 10 to 25% by weight based on the total amount of the comonomers. When the amount of comonomer (ii) is below this range, it becomes difficult to perform development with an aqueous alkaline solution, while when it is above this range, no sufficient flexibility can be obtained.

Specific examples of the above-described comonomer (ii) include acrylic acid, methacrylic acid,

$CH_2$=CH-COO-$CH_2$-$CH_2$-OCO-COOH

$CH_2$=C-COO-$CH_2$-$CH_2$-OCO-COOH,
|
$CH_3$

$CH_2$=CH-COO-$CH_2$-$CH_2$-OCO-$CH_2$-COOH

$CH_2$=C-COO-$CH_2$=$CH_2$-OCO-$CH_2$-COOH,
|
$CH_3$

$CH_2$=CH-COO-$CH_2$-$CH_2$-OCO-($CH_2$)$_2$-COOH,

$CH_2=C-COO-CH_2-CH_2-OCO-(CH_2)_2-COOH$ 、
|
$CH_3$

$CH_2=CH-COO-CH_2-CH_2-OCO-(CH_2)_3-COOH$、

$CH_2=C-COO-CH_2-CH_2-OCO-(CH_2)_3-COOH$ 、
|
$CH_3$

$CH_2=CH-COO-CH_2-CH_2-OCO-(CH_2)_4-COOH$、

$CH_2=C-COO-CH_2-CH_2-OCO-(CH_2)_4-COOH$ 、
|
$CH_3$

$CH_2=CH-COO-CH_2-CH_2-OCO-(CH_2)_5-COOH$、

$CH_2=C-COO-CH_2-CH_2-OCO-(CH_2)_5-COOH$ 、
|
$CH_3$

$CH_2=CH-COO-CH_2-CH_2-OCO-(CH_2)_6-COOH$、

$CH_2=C-COO-CH_2-CH_2-OCO-(CH_2)_6-COOH$ 、
|
$CH_3$

$CH_2=CH-COO-CH_2-CH_2-OCO-(CH_2)_7-COOH$、

$CH_2=C-COO-CH_2-CH_2-OCO-(CH_2)_7-COOH$ 、
|
$CH_3$

$CH_2=CH-COO-CH_2-CH_2-OCO-(CH_2)_8-COOH$、

$CH_2=C-COO-CH_2-CH_2-OCO-(CH_2)_8-COOH$ 、
|
$CH_3$

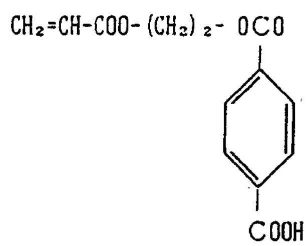

、

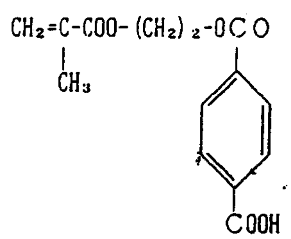

、

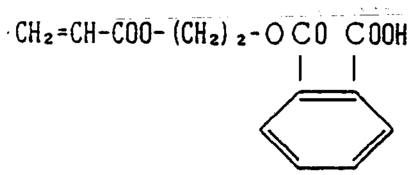
,

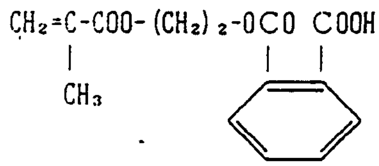
,

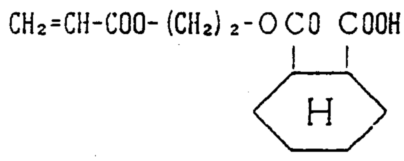
,

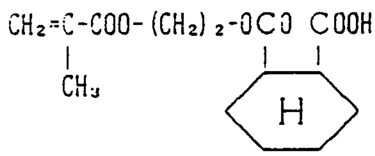
,

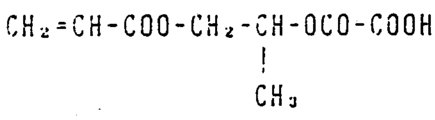
,

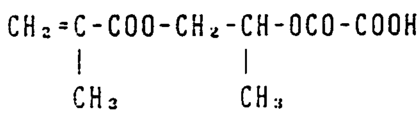
,

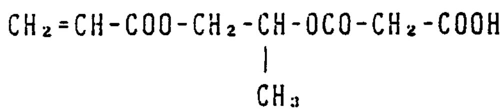
,

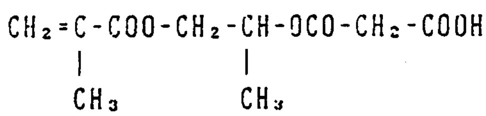
,

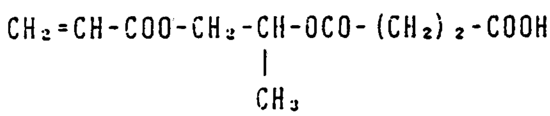
,

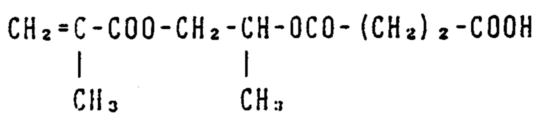
,

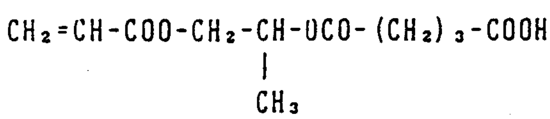
,

$CH_2=C-COO-CH_2-CH-OCO-(CH_2)_3-COOH$、
$\quad\ \ |\qquad\qquad\quad |$
$\quad CH_3\qquad\quad CH_3$

$CH_2=CH-COO-CH_2-CH-OCO-(CH_2)_4-COOH$ 、
$\qquad\qquad\qquad\qquad |$
$\qquad\qquad\qquad\ CH_3$

$CH_2=C-COO-CH_2-CH-OCO-(CH_2)_4-COOH$、
$\quad\ \ |\qquad\qquad\quad |$
$\quad CH_3\qquad\quad CH_3$

$CH_2=CH-COO-CH_2-CH-OCO-(CH_2)_5-COOH$ 、
$\qquad\qquad\qquad\qquad |$
$\qquad\qquad\qquad\ CH_3$

$CH_2=C-COO-CH_2-CH-OCO-(CH_2)_5-COOH$、
$\quad\ \ |\qquad\qquad\quad |$
$\quad CH_3\qquad\quad CH_3$

$CH_2=CH-COO-CH_2-CH-OCO-(CH_2)_6-COOH$ 、
$\qquad\qquad\qquad\qquad |$
$\qquad\qquad\qquad\ CH_3$

$CH_2=C-COO-CH_2-CH-OCO-(CH_2)_6-COOH$、
$\quad\ \ |\qquad\qquad\quad |$
$\quad CH_3\qquad\quad CH_3$

$CH_2=CH-COO-CH_2-CH-OCO-(CH_2)_7-COOH$ 、
$\qquad\qquad\qquad\qquad |$
$\qquad\qquad\qquad\ CH_3$

$CH_2=C-COO-CH_2-CH-OCO-(CH_2)_7-COOH$、
$\quad\ \ |\qquad\qquad\quad |$
$\quad CH_3\qquad\quad CH_3$

$CH_2=CH-COO-CH_2-CH-OCO-(CH_2)_8-COOH$ 、
$\qquad\qquad\qquad\qquad |$
$\qquad\qquad\qquad\ CH_3$

$CH_2=C-COO-CH_2-CH-OCO-(CH_2)_8-COOH$、
$\quad\ \ |\qquad\qquad\quad |$
$\quad CH_3\qquad\quad CH_3$

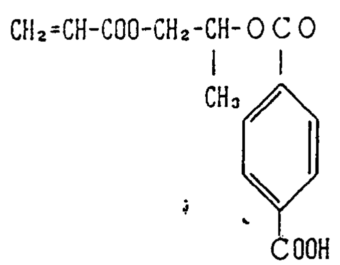
、

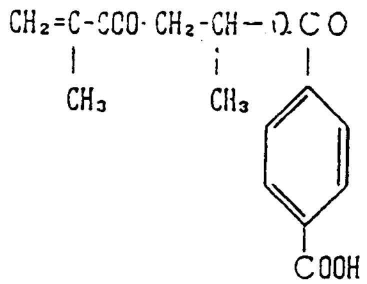

,

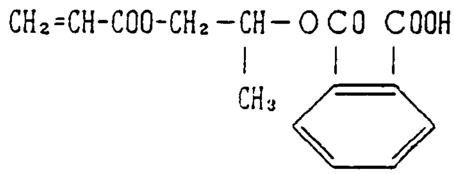

,

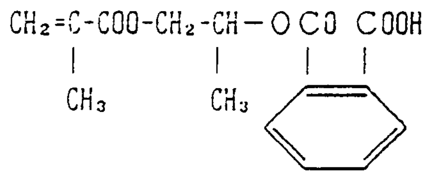

,

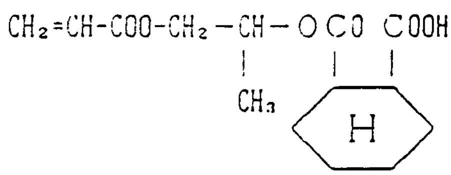

,

and 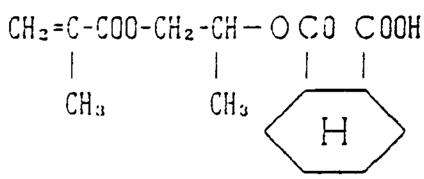

though not limited to these only.

The use of acrylonitrile or methacrylonitrile as the above-described copolymerizable monomer (iii) in an amount 10 to 30% by weight based on the total amount of the comonomers favorably improves not only the resistance or the resist film to the etchant or plating solution but also adhesion and flexibility.

Component (a) of the present invention has a weight-average molecular weight of 30,000 to 200,000, a glass transition point of 20 to 80 °C, and an acid value of 50 to 150. When the weight-average molecular weight is below this range, the strength of the resist pattern becomes insufficient, while when it is above this range, the adhesion to the board becomes poor. When the glass transition point is below this range and a laminate having a three-)ayer structure is formed therefrom, the photopolymerizable resin layer often leaches at room temperature from the laminate, which makes it impossible to use the laminate as the dry film resist. On the other hand, when the glass transition point is above this, it is impossible to fill up an uneven portion when the composition is laminated on a substrate having an uneven surface.

Component (b)

Component (b) of the photopolymerizable resin composition according to the present invention is an ethylenically unsaturated compound which forms a polymer through the action of a photopolymerization initiator, and examples of such a compound include esters of acrylic acid, esters of methacrylic acid, acrylamides, methacrylamides, allyl compounds, vinyl ether compounds, and vinyl ester compounds.

Examples of the alcohol constituting the ester of acrylic or methacylic acid include propyl alcohol, ethylene glycol, polyethylene glycol, propylene glycol, polypropylene glycol, neopentyl glycol, trimethylolpropane, pentaerythritol, butanediol, and trimethylolethane.

Examples of the acrylamides and methacrylamides include, besides methylenebisacrylamide and methylenebismethacrylamide, an amide of a polyamine, such as ethylenediamine or hexamethylenediamine, with acrylic or methacrylic acid.

Examples of the allyl compound include diallyl esters of phthalic acid, adipic acid, malonic acid, etc.

The vinyl ether compound is a polyvinyl ether of a polyhydric alcohol, and examples of the polyhydric alcohol include ethylene glycol, polyethylene glycol, propylene glycol, polypropylene glycol, neopentyl glycol, trimethylolpropane, pentaerythritol, butanediol, and trimethylolethane.

Examples of the vinyl ester compound include divinyl succinate, divinyl adipate, and divinyl phthalate.

The content of the above-described component (b) in the photopolymerizable resin composition of the present invention is 10 to 100 parts by weight based on 100 parts by weight of the above-described component (a).

Component (c)

Component (c) of the photopolymerizable resin composition according to the present invention is a photopolymerization initiator which initiates polymerization of the above-described ethylenically unsaturated compound component (b), upon being exposed to an actinic radiation. Examples of component (c) include anthraquinone, its derivatives such as 2-methylanthraquinone and 2-ethylanthraquinone, benzoin, its derivatives such as benzoin methyl ether, benzophenone, phenanthrenequinone, and 4,4'-bis-(dimethylamino) benzophenone.

These photopolymerization initiator components (c) may be used alone or in any combination of two or more of them.

The content of the above-described component (c) in the photopolymerizable composition of the present invention is 1 to 15 parts by weight based on 100 parts by weight of the above-described component (a).

(Auxiliary component)

The photopolymerizable resin composition of the present invention may contain, besides the above-described components, auxiliary components such as heat polymerization inhibitor, dyes, pigments, coating aids, flame retardants and flame retardant aids. Criterion for selection of these auxiliary components is the same as that in the case of the conventional photopolymerizable composition.

Component (d)

The incorporation of benzotriazolecarboxylic acid, such as carboxybenzotriazole, in an amount of 0.005 to 3 parts by weight based on 100 parts by weight of the above-described component (a) favorably contributes to a further improvement in the adhesion.

(Method of use)

The photopolymerizable resin composition of the present invention is used by dissolving each of the components in a suitable solvent followed by mixing together.

Representative examples of the suitable solvent include methyl ethyl ketone, ethyl acetate, toluene, methylene chloride, and trichloroethane, though it is not limited to these only.

When the photopolymerizable resin composition of the present invention is used, either a solution prepared by dissolving the components in the above-described solvent is directly applied to a substrate, e.g., a copper-clad laminate and dried to form a resist film, or the above-described solution is applied on, e.g., a polyester film as a support film and dried to form a resist film, and the resist film is heat-laminated on a copper-clad laminate. In this case, the thickness of the resist film is preferably 25 to 50 $\mu$m. Then, an actinic radiation is selectively applied to the resist film and development is conducted to form a resist image on the substrate. Copper surface portions not protected by the resist image are subjected to etching treatment or metal plating to prepare a printed circuit board.

(Developer)

The developer used for development after selective exposure of a resist film prepared from the photopolymerizable resin composition of the present invention is an aqueous weakly alkaline solution.

Examples of a base used for preparation of the weakly alkaline solution include alkaline hydroxides, i.e., hydroxides of lithium, sodium or potassium; alkaline carbonates, i.e., carbonate and bicarbonate of lithium, sodium or potassium; alkaline metal phosphates such as sodium phosphate and potassium phosphate; alkaline metal pyrophosphates such as sodium pyrophosphate and potassium pyrophosphate; primary amines such as benzylamine and butylamine; secondary amines such as dimethylamine; benzylmethylamine, and diethanolamine; tertiary amines such as trimethylamine, triethylamine, and triethanolamine; cyclic amines such as morpholine, piperazine, piperidine, and pyridine; polyamines such as ethylenediamine and hexamethylenediamine; ammonium hydroxides such as tetramethylammonium hydroxide, tetraethylammonium hydroxide, trimethylbenzylammonium hydroxide, and trimethylphenylammonium hydroxide; and sulfonium hydroxides such as trimethylsulfonium hydroxide, diethylmethylsulfornium hydroxide, and dimethylbenzylsulfonium hydroxide.

EMBODIMENTS OF THE INVENTION

The present invention will now be described in more detail by way of Examples.

Examples 1 and 2 and Comparative Examples 1 and 2

Photopolymerizable resin composition solutions were prepared by making use of linear acrylic copolymers listed in the following Table 1 according to the following recipe.

Table 1

| | Linear acrylic copolymer |
|---|---|
| Ex. 1 | methyl methacrylate/methacrylic acid/2-hydroxypropyl methacrylate/acrylonitrile/ ethyl methacrylate (weight ratio: 20/20/20/20 20) copolymer (average molecular weight: about 50,000) |
| Ex. 2 | ethyl acrylate/methacrylic acid/2-hydroxyethyl methacrylate/acrylonitrile/ethyl methacrylate (weight ratio: 20/20/10/20/30) copolymer (average molecular weight: about 50,000) |
| Comp. Ex. 1 | methyl methacrylate/methacrylic acid/ acrylonitrile/ethyl methacrylate (weight ratio: 40/20/20/20) copolymer (average molecular weight: about 50,000) |
| Comp. Ex. 2 | methyl methacrylate/methacrylic acid/acrylonitrile/ethyl methacrylate (weight ratio: 30/30/20/20) copolymer (average molecular weight: about 50,000) |

| Recipe | |
|---|---|
| linear acrylic copolymer (see Table 1) | 100 parts by weight |
| trimethylolpropane triacrylate | 15 parts by weight |
| tetraethylene glycol diacrylate | 20 parts by weight |
| benzophenone | 5 parts by weight |
| 4,4'-bis(dimethylamino)benzophenone | 0.6 parts by weight |
| crystal violet | 0.1 part by weight |
| carboxybenzotriazole | 0.1 part by weight |
| methyl ethyl ketone | 300 parts by weight |

Each of the photopolymerizable resin composition solutions prepared above was uniformly applied to a 25 µm-thick polyethylene terephthalate film and dried to form a 30 µm-thick resist film. The formed film having a resist coating was laminated on a flexible substrate comprising a 0.2 mm-thick polymide film and a 35 µm-thick copper layer formed thereon in such a manner that said copper layer faces said resist coating. An actinic radiation of 90 mJ/$cm^2$ was applied from the side of the polyethylene terephthalate film through a negative film by means of a 3 kW ultrahigh pressure mercury lamp (Model HMW-201B; mfd. by ORC), and the polyethylene terephthalate film on the resist film was then removed. Thereafter, development was

conducted by making use of a 1.5% aqueous sodium carbonate solution at 32°C for 80 seconds with a spray developing machine, followed by washing with water and drying.

The flexible substrate having a resist pattern formed thereon was bent for about 1 second around a metal rod having a diameter of 10, 20, 30 or 40 in. so as to have a U-shape to observe the state of occurrence of cracking on the surface of the resist pattern. The results are shown in Table 2.

Table 2

| | 40 in. | 30 in. | 20 in. | 10 in. |
|---|---|---|---|---|
| Ex. 1 | A | A | A | C |
| Ex. 2 | A | A | A | C |
| Comp. Ex. 1 | B | C | C | C |
| Comp. Ex. 2 | A | B | C | C |

Note: The criteria for evaluation are as follows:

- A: occurrence of no crack
- B: occurrence of crack in a very limited portion of the surface of the resist pattern
- C: occurrence of crack all over the surface of the resist pattern

ADVANTAGE OF THE INVENTION

The photopolymerizable resin composition of the present invention wherein a particular linear acrylic copolymer is used can afford a resist film having excellent flexibility and adhesion. Therefore when, for example, a printed circuit board is prepared by making use of the photopolymerizable resin composition of the present invention, occurrence of defectives can be remarkably lowered because no crack occurs on the resist film and no etchant penetrates into the gap formed between the resist film and the surface of the board.

## Claims

**1.** Photopolymerizable resin composition which is suitable for the production of a printed circuit board and may be developed with an aqueous alkaline solution, characterized in that the composition is mainly composed of:

a) a linear acrylic copolymer, having a weight-average molecular weight of 30,000 to 200,000 and a glass transition of 20° to 80°C, and comprising

(i) at least one comonomer represented by the following general formula:

$$CH_2=\underset{\displaystyle X}{\underset{|}{C}}-CO-Y-Z-OH$$

wherein

- X is a hydrogen atom or a methyl group
- Y is an oxygen atom or an imino group and
- Z is an alkylene group having 1 to 5 carbon atoms,

in an amount of 1 to 30 wt.% based on the total amount of the comonomers;

(ii) an ethylenically unsaturated comonomer having a carboxyl group in a amount of 10 to 25 wt.%, based on the total amount of the comonomers; and

iii) at least one comonomer selected from the group consisting of acrylonitrile and methacrylonitrile in an amount of 10 to 30 wt.% based on the total amount of the comonomers;

b) an ethylenically unsaturated compound in an amount of 10 to 100 parts by weight based on 100 parts by weight of the linear acrylic copolymer;

c) a photopolymerizable initiator in an amount of 1 to 15 parts by weight based on 100 parts by weight of the linear acrylic copolymer; and

d) a benzotriazolecarboxylic acid.

## Patentansprüche

1. Für die Herstellung von gedruckten Schaltungen und mit einer wässrigen alkalischen Lösung entwickelbare photopolymerisierbare Harzzusammensetzung, dadurch gekennzeichnet, daß die Zusammensetzung im wesentlichen besteht aus:

   (a) einem linearen Acryl-Copolymer mit einem durchschnittlichen Molekulargewicht von 30,000 to 200,000 und einem Glasübergang bei 20° to 80°C, mit:

   (i) mindestens einem Comonomer, repräsentiert durch die folgende allgemeine Formel:

$$CH_2 = \underset{X}{C} - CO - Y - Z - OH$$

   wobei

   x Wasserstoff oder eine Methyl Gruppe,
   Y Sauerstoff oder eine Imino Gruppe und
   Z eine Alkylen-Gruppe mit 1 to 5 C-Atomen, sein kann,

   zu 1 to 30 Gewichtsprozent, basierend auf der Gesamtmenge der Comonomere;

   (ii) einem ethylenisch ungesättigten Comonomer mit einer Carboxyl-Gruppe zu 10 to 25 Gewichtsprozent, basierend auf the Gesamtmenge Comonomere; und

   (iii) mindestens einem Comonomer ausgewählt aus der Gruppe bestehend aus Acrylnitril und Meth-Acrylnitril - zu 10 bis 30 Gewichtsprozent, basierend auf der Gesamtmenge Comonomere,

   b) einer ethylenisch ungesättigten Verbindung in einer Menge von 10 bis 100 Gewichtsteilen, basierend auf 100 Gewichtsteilen lineares Acryl-Copolymer;

   c) einem photopolymerisierbaren Initiator zu 1 bis 15 Gewichtsteilen, basierend auf 100 Gewichtsteilen lineares Acryl-Copolymer; und

   d) einer Benzotriazol-Carboxyl-Säure.

## Revendications

1. Composition de résine photopolymérisable convenant à la production d'une carte de circuits imprimés et qui peut être développée par une solution alcaline aqueuse, caractérisée en ce que la composition est principalement composée des substances suivantes :

   a) un copolymère acrylique linéaire ayant un poids moléculaire moyen en poids de 30.000 à 200.000 et un point de transition vitreuse de 20 à 80°C et comprenant :

   (i) au moins un comonomère représenté par la formule générale suivante :

$$CH_2{=}\underset{X}{C}{-}CO{-}Y{-}Z{-}OH$$

   dans laquelle :

   X est un atome d'hydrogène ou un groupe méthyle,
   Y est un atome d'oxygène ou un groupe imino et
   Z est un groupe alkylène ayant 1 à 5 atomes de carbone,

   en quantité de 1 à 30 % en poids sur base de la quantité totale des comonomères,

   (ii) un comonomère à insaturation éthylénique ayant un groupe carboxyle à raison de 10 à 25 % en poids sur base de la quantité totale des comonomères,

   (iii) au moins un comonomère choisi parmi l'acrylonitrile et le méthacrylonitrile à raison de 10 à 30 % en poids sur base de la quantité totale des comonomères,

   b) un composé à insaturation éthylénique à raison de 10 à 100 parties en poids sur base de 100 parties en poids du copolymère acrylique linéaire,

   c) un initiateur photopolymérisable à raison de 1 à 15 parties en poids sur base de 100 parties en poids du copolymère acrylique linéaire, et

   d) un acide benzotriazolecarboxylique.